# EUROPEAN PATENT APPLICATION

(11) **EP 3 514 827 A1**
(43) Date of publication of application: **24.07.2019**
(21) Application number: 18152271.5
(22) Date of filing: 18.01.2018
(51) Int. Cl.: H01L 23/367, H01L 23/427

(54) **HEATSINK, HEATSINK INSERT AND METHOD OF MANUFACTURING A HEATSINK**

(71) Applicant: ABB Schweiz AG, 5400 Baden (CH)
(72) Inventor: Silvennoinen, Mika, 00380 Helsinki (FI); Manninen, Jorma, 00380 Helsinki (FI); Pakarinen, Joni, 00380 Helsinki (FI)
(74) Representative: Kolster Oy Ab

(57) **Abstract**

A heatsink, a heatsink insert and a method of manufacturing a heatsink. The heatsink having a heatsink body (1) with a base plate (2) having a surface arranged to receive a heat source (3) in mating connection. The base plate (2) comprises at least one insert (4) attached to the base plate and made from a material having a higher thermal conductivity than the base plate and the heatsink comprises at least one heat transferring element (5) embedded in the at least one insert (4) and a surface of the at least one insert is adapted to form at least part of the surface that is arranged to receive a heat source (3) in mating connection.

## Description

### FIELD OF THE INVENTION

The present invention relates to heatsinks, and particularly to heatsinks for power electronic modules.

### BACKGROUND OF THE INVENTION

Power electronic modules are used in power electronic devices such as inverters or frequency converters. One power electronic module comprises multiple of power electronic switches which are capable of switching high currents and able to withstand high voltages over the components. In many devices, such as inverters and frequency converters, the operation is based in operating power electronic switches with a high frequency to produce a desired voltage or current to a load.

Power electronic modules' heat loss is dissipated mainly via its base plate that has to be in good thermal connection with a cooling device like air cooled heatsink, liquid cold plate or thermosyphon heatsink. The thermal characteristics of the cooling device have to be designed according to both the power electronic module and its usage profile.

A frequency converter or an inverter of a high speed motor drive has increased heat losses because of higher switching frequency. Further high power cyclic applications have higher thermal induced stresses within the power electronic module. Conventional aluminum heatsinks' thermal characteristics are well known and utilized quite well too. However, the increasing heating power density (W/cm2) of power electronic modules requires more efficient cooling solutions. Also, the common aluminum heatsinks' time constants are insufficient (too long) for the high power cyclic applications. Much faster response is needed to avoid excessive junction temperatures and to achieve long service life.

Specific heatsink designs have been developed to both reduce thermal resistance and enhance their power cycle response. These heatsink improvements relate, for example, to special cooling fin designs for enhanced surface area and/or enhanced heat transfer coefficient, combination of different construction materials (Al+Cu), and use of two-phase construction parts like heat-pipes for increased heat spreading within the heatsink. Especially the two-phase heatsinks are proven to work well in many thermally demanding applications.

The common heatsink design problem relates to insufficient cooling fin efficiency. Aluminum is relatively inexpensive material and easy to manufacture but its thermal conductivity (k∼200 W/mK) is often insufficient. Copper fins or base plate inserts (k∼380 W/mK) are commonly considered but this increases the total weight and cost significantly.

### BRIEF DESCRIPTION OF THE INVENTION

An object of the present invention is to provide a heatsink, a heatsink insert and a method of manufacturing a heatsink so as to alleviate the above disadvantages. The objects of the invention are achieved by a heatsink, a heatsink body, a heatsink insert and a method, which are characterized by what is stated in the independent claims. The preferred embodiments of the invention are disclosed in the dependent claims.

The invention is based on the idea of providing a heatsink that is formed of a body, which is typically of aluminium, and of a heatsink insert that is of material having a higher thermal conductivity than the body of the heatsink and is attached to the body. At least one heat transferring element is further embedded in the insert either completely or partly.

The heatsink insert forms a part of the surface of the heatsink and the insert spreads effectively the heat from a power electronic module to the mass of the heatsink thereby providing effective thermal management for the power electronic module connected to the heatsink.

The heatsink body comprises preferably an indent which is adapted to receive a heatsink insert. The body is preferably made from aluminium using typical fabrication methods. The indent of the surface of the body for receiving a heat transferring insert is fabricated according to specific design thereby enabling to produce efficient cooling for a specified purpose.

The heatsink insert of the invention is adapted to be attached to base plate of the heatsink body and comprises at least one heat transferring element for transferring and spreading heat. The heatsink insert is preferably material that has a substantially high thermal conductivity, such as copper. The number, position, orientation and size of the heat transferring elements in the insert can be designed according to a specific need, i.e. the insert is designed according to the type of a power electronic module that requires temperature management. Further, if the type of use of the device in which the power electronic module is known, such type of use can be taken into account in designing the insert.

The method of the invention produces a heatsink. In the method, a heatsink body is and a heatsink insert with at least one heat transferring element are provided. The insert is further attached to the body in thermally conducting manner.

The heatsink of the invention has thermal properties that enable to use a power electronic module in an efficient manner. The thermal properties of the heatsink can be designed according to intended use by designing the heatsink insert to take into account the locations of the heat producing components of the module. The heat transferring element of the heatsink is preferably a heat pipe, vapor chamber, graphite material structure or graphene material structure. Further, the costs of the heatsink are comparatively low as the heatsink body can be mass produced and it is of common design. The indent in the heatsink body is made according to the dimensions of the heatsink insert which again is thermally dimensioned to suit the desired use or application.

### BRIEF DESCRIPTION OF THE DRAWINGS

In the following the invention will be described in greater detail by means of preferred embodiments with reference to the attached drawings, in which
Figure 1 shows a cross-section of an embodiment of the heatsink of the invention;
Figure 2 shows a perspective view of an embodiment of the heatsink;
Figure 3 shows a bottom view of an embodiment of the heatsink;
Figure 4 shows an example of orientation of heat pipes in a heatsink insert;
Figure 5 shows a cross-section of an embodiment of the heatsink; and
Figure 6 shows a perspective view of the heatsink of Figure 5.

### DETAILED DESCRIPTION OF THE INVENTION

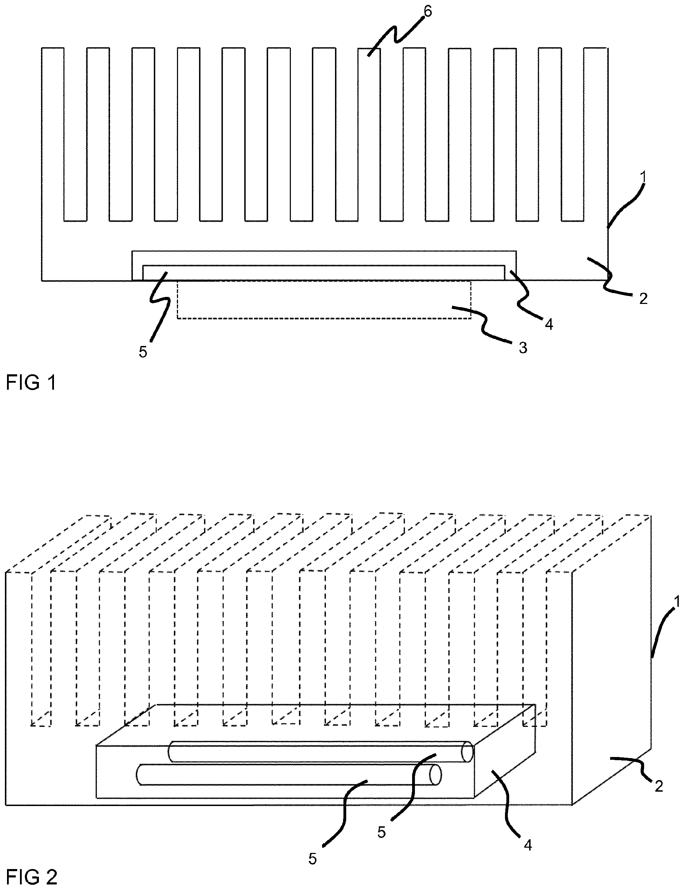

Figure 1 shows a cross-section of a heatsink according to an embodiment of the invention. The heatsink comprises a heatsink body 1 which is preferably aluminium extruded profile. The heatsink has a heatsink body 1 with a base plate 2. In use a heat source 3, such as a heat generating component that is to be cooled, is attached to a surface of the heatsink body in thermal connection. The surface is arranged to receive a heat source in mating connection. The heat source, such as power electronic module, has a heat transferring surface which is attached against the surface of the heatsink.

According to the invention, a heatsink insert 4 is attached to the heatsink body. In the example of Figure 1 the heatsink body 1 has an indent to which the insert 4 is placed and fastened. The bottom surface of the heatsink is formed of the surface of the heatsink body and of the surface of the heatsink insert. The heatsink insert is made of a material that has a higher thermal conductivity than the heatsink body.

Further, the heatsink insert comprises at least one heat transferring element 5 embedded in the insert 4. In the example of Figure 1, the heat transferring element is shown to be situated in the surface of the insert in such a manner that the surface of the heat pipe forms a part of the surface of the insert. However, the heat transferring element may be completely embedded inside the insert.

In the example shown in Figure 1, in addition to heatsink base plate 2, the heatsink body comprises also heatsink fins 6 which are used for enhancing the transfer of heat from the heatsink to the surrounding air. The fins of the heatsink are, however, optional and effective cooling is obtained also without the fins.

Figure 1 shows a cross section of an embodiment in which the heatsink insert has a larger surface area than the surface area of the attached power electronic module. That is, the heat generating component is below the surface of the heatsink insert and therefore the heat generating surface of the component is not in contact with the base plate of the heatsink. A heat generating component can also be attached to the heatsink such that part of the component is in connection with surface of the heatsink base plate and other part of the component is in connection with surface of the heatsink insert. In such a case the surfaces of the heatsink base plate and the insert need to be in the same level so that a planar surface of the heat generating component can be attached in a thermally conductive manner.

The base plate of the heatsink has preferably an indent to which the heatsink insert can be attached. The indent is preferably dimensioned to receive the insert such that the surfaces of the insert and the base plate are at same level. When the insert is in a recess in the base plate, the heat from the heat generating component is effectively led through the insert to the heatsink body. The indent of the base plate may also be higher than the height of the insert or the indent may be lower than the height of the insert. Further, a thermal interface material may be disposed between the surface of the heat generating component and the surface of the heatsink.

Figure 2 shows perspective view of the embodiment shown in Figure 1. In Figure 2, certain parts of the structure are shown as transparent such that the heatsink insert is revealed. Further, the heat transferring elements 5 which are situated inside the insert 4 are visible to clarify the idea of the invention.

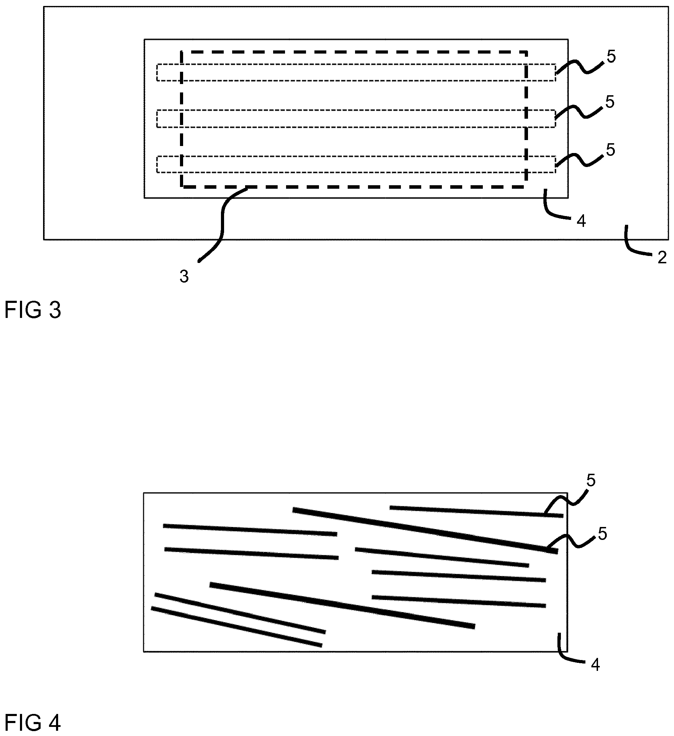

Figure 3 shows a bottom view of an embodiment of the heatsink of the invention. The insert 4 is attached to the base plate 2 of the heatsink and the heat transferring elements 5 inside the insert are shown with dashed lines. Figure 3 shows three heat pipes arranged in the insert and the heat pipes are in parallel orientation. The attached heat source 3, such as a power electronic module, is also shown with dashed lines. In the example of Figure 3 the heat source is shown to be positioned against the heatsink insert 3.

According to the invention, the heatsink of the invention comprises at least one heat transferring element embedded in the heatsink insert. According to preferred embodiments, the heat transferring element is a heat pipe, vapor chamber, graphite material structure or graphene material structure. The heat transferring element is thus an element, which transfers and spreads heat efficiently in the insert. The attached drawings and the specification uses heat pipes as an example of heat transferring element. It is, however, clear that any other heat transferring element may be applied in the insert in a similar manner.

Figure 2 shows as an example two heat pipes 5 completely inside the insert while Figure 3 shows three parallel heat pipes inside the insert 4. Figure 4 shows a bottom view of an example of a heatsink insert showing the placement of the heat pipes in the insert. As seen from Figure 4, the insert may comprise multiple of heat pipes. Further, the heat pipes may be oriented as desired so that the transfer of heat is efficient. Figure 4 also shows that the insert may hold heat pipes that have different dimensions, i.e. length and/or width.

The purpose of the heatsink insert and the heat pipes is to transfer the heat generated by the heat source, such as power electronic module, to the heatsink body and further to surrounding air. The heat pipes, which are known as such, are effective in transferring heat from the power electronic module attached to the heatsink. The heatsink insert is from a material having a higher thermal conductivity than the base plate to which it is attached. Preferably, the heatsink baseplate and the heatsink body are fabricated from aluminium and the heatsink insert is of copper. Other suitable materials for the heatsink insert include gold, silver and synthetic diamond. The heatsink insert material may also be alloy of different materials. When the heatsink insert has a high thermal conductivity, the heat is transferred effectively to the heat pipes from the heat source and from the heat pipes to the heatsink body.

The heat pipes in the insert may be positioned in multiple of layers inside the insert. That is, one or more of the heat pipes may be situated closer to the bottom surface of the insert than other heat pipes. Further, one or more heat pipes may be inclined inside the insert. When a heat pipe is inclined, the distance from its one end to the bottom surface of the insert differs from the distance from its other end to the bottom surface of the insert.

The at least one heat pipe has preferably a shape of a cylinder. However, when one or more heat pipes are arranged to form a part of a surface of the insert, such heat pipe is preferably shaped to have a flat longitudinal surface. When a heat pipe has a flat longitudinal surface the heat pipe can be formed as a half cylinder. However, the shape of the heat pipe is not limited to a cylinder or a half cylinder, but can also have a cross section having an arc joined by a straight line or a C- or U- shaped curve closed by a straight line. When a flat surface forms a part of the surface of the heatsink insert, the heat from the heat source is transferred directly from the heat source to the heat pipe.

The heatsink insert is designed according to the heat source that is to be cooled. When for example the heat source is a power electronic module, the heat pipes of the insert can be designed such that the heat transfer from the hottest spots of the power electronic module is efficient. This can be achieved by placing a separate heat pipe for each of switch component of the power electronic module. For example, if a power electronic module has IGBT switch components in known positions, then the heat pipes of the insert are placed to such positions in the insert that the heat transfer from the IGBT switch components is efficient once the module is attached to the heatsink.

According to an embodiment of the invention, the heatsink insert comprises further one or more external heat pipes which extend from the heatsink insert outside the heatsink insert. The first ends of the one or more external heat pipes are attached to the heatsink insert and the second ends of the heat pipes are outside the heatsink insert.

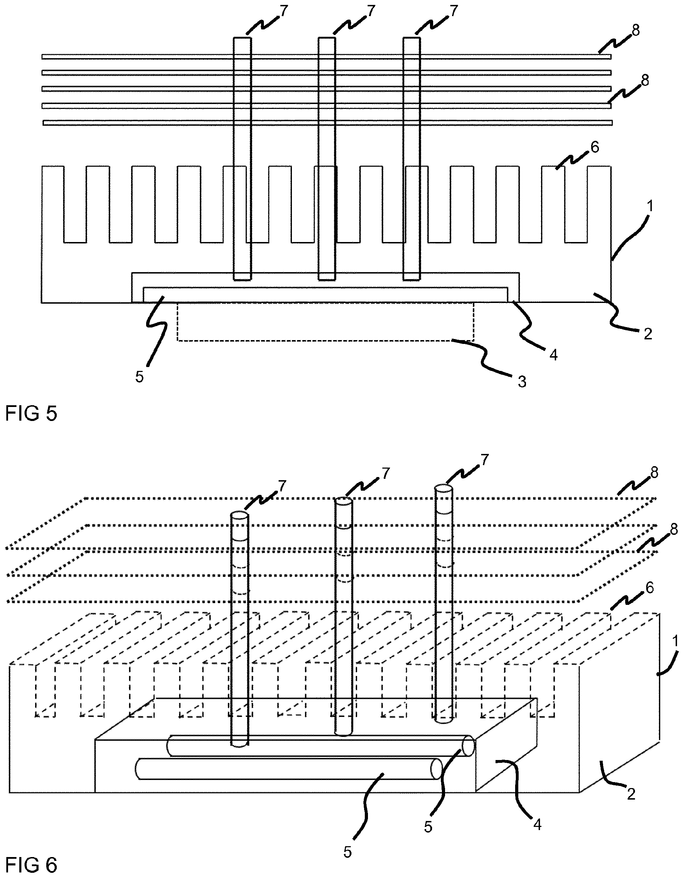

Figure 5 shows an embodiment in which three external heat pipes 7 are attached to the heatsink insert 4. When a bottom surface of the heatsink insert and heatsink is defined as the surface to which the heat source is to be attached, the external heat pipes extend from the heatsink insert in the direction opposite to the bottom surface. The external heat pipes 7 in Figure 5 are shown to have cooling fins 8 or plates attached to the heat pipes for further improving the heat transfer from the heatsink insert. Figure 6 shows a perspective view of an embodiment with external heat pipes with cooling fins 8. The perspective view of Figure 8 is shown partly open to reveal the components of the heatsink.

The heatsink insert of the invention comprises at least on heat transferring element embedded at least partly in the heatsink insert. The heatsink insert is made of a material having a high thermal conductivity, preferably of a material having a higher thermal conductivity than that of aluminium. Preferably the material of the heatsink insert is aluminium, copper, silver, gold or synthetic diamond. The material of the insert may also be an alloy or mixture of materials that provides a high thermal conductivity.

In an embodiment at least one heat transferring element of the heatsink insert is adapted to form a part of a surface of the heatsink insert. The heatsink insert is typically a piece which is defined by its bottom and top surfaces and side walls. The bottom surface is adapted to receive a heat source while the top surface is adapted to be attached against a heatsink body. The surface of which a part is formed from a surface of a heat transferring element is the bottom surface. As described in connection with the heatsink of the invention, the heat transferring elements of the insert may have different cross sections. In an embodiment where a part of a surface of the insert is formed of a surface of at least one heat transferring element, the at least one heat transferring element has a longitudinal flat surface that forms a part of the bottom surface of the insert. The heat transferring element is preferably a heat pipe, vapor chamber, or graphite or graphene material structure.

Further, the heatsink insert may comprise heat transferring elements, such as heat pipes, with different sizes and orientations. The heat transferring elements may also be inclined or positioned in different layers inside the insert as already described above.

The invention enables to design a cost effective heatsink for specific purposes and specific heat sources, such as power electronic modules. The heatsink body with the heatsink base plate and the optional heatsink fins are produced in an effective manner preferably by aluminium extrusion. Although extruded aluminium profile is preferred, the heatsink body is not limited to specific manufacturing method or material. The heatsink body may also be a stamped heatsink, die casted heatsink, skived fin heatsink, folded fin heatsink, milled/machined heatsink, crimped fin heatsink, bonded fin heatsink or brazed fin heatsink.

The heatsink body is prepared for specific use when the heatsink insert is first designed. The outer dimension of the heatsink insert defines the dimensions of an indent produced to the base plate of the heatsink if the insert is to be placed to a recess. Further, the power electronic module and the use of the device employing the power electronic module defined the design of the heatsink insert. If, for example, it is known that the use of the device will be highly cyclic, then the temperature cycling is to be reduced while still keeping the highest temperatures at a certain level. Thus once the physical size, the placement of heat generating components in a heat source and the intended use are known, the heatsink insert with the embedded heat transferring elements is manufactured.

Based on the dimensions of the heatsink insert, the heatsink body is prepared such that the insert can be attached to the body in thermally conductive manner. The preparation of the heatsink body may include drilling, machining and cutting of the body, for example. According to the method of the invention, a heatsink body is provided, a heatsink insert with at least one embedded heat transferring element is provided, and the heatsink body is attached to the heatsink insert. The attachment of the heatsink body and the insert may comprise fastening the insert to the heatsink body using screws or welding the insert to the heatsink body. Also other types of attachments may be used to secure the insert to the heatsink body.

As it is understood, the heatsink insert is substantially solid plate-like member which is able to withstand mechanical forces due to attachment of a heat source, such as a power electronic module to the heatsink. The power electronic module is attached to the heatsink such that the heat transfer from the module to the heatsink is effective. Although it was shown in the drawings that the surface area of the heat source is smaller than the area of the bottom of the insert, the heat source, such as power electronic module, can be attached to the base plate of the heatsink.

It will be obvious to a person skilled in the art that, as the technology advances, the inventive concept can be implemented in various ways. The invention and its embodiments are not limited to the examples described above but may vary within the scope of the claims.

## Claims

1. A heatsink having a heatsink body (1) with a base plate (2) having a surface arranged to receive a heat source (3) in mating connection, wherein
the base plate (2) comprises at least one insert (4) attached to the base plate and made from a material having a higher thermal conductivity than the base plate and
the heatsink comprises at least one heat transferring element (5) embedded in the at least one insert (4) and a surface of the at least one insert is adapted to form at least part of the surface that is arranged to receive a heat source (3) in mating connection.

2. A heatsink according to claim 1, wherein the at least one heat transferring element embedded in the insert is embedded completely inside the insert.

3. A heatsink according to claim 1, wherein the at least one heat transferring element embedded in the insert is partly embedded such that a part of the at least one heat transferring element forms a part of the surface of the insert.

4. A heatsink according to claim 3, wherein the at least one heat transferring element forming a part of the surface of the insert comprises a substantially flat and elongated surface.

5. A heatsink according to any one of the previous claims 1 to 4, wherein the heatsink insert comprises multiple of heat transferring elements and at least one heat transferring element is inclined inside the heatsink insert.

6. A heatsink according to any one of the previous claims 1 to 5, wherein the heatsink insert comprises multiple of heat transferring elements and at least some of the heat transferring elements are arranged in differing orientation.

7. A heatsink according to any one of the previous claims 1 to 6, wherein the heatsink insert comprises further one or more external heat pipes, the external heat pipes extending from the heatsink insert outside the heatsink insert and a heatsink body formed of the heatsink base plate and additional heatsink fins.

8. A heatsink according to claim 7, wherein the one or more external heat pipes comprises first and second ends, the first ends being arranged in the heatsink insert and the second ends being arranged outside the heatsink body.

9. A heatsink according to any one of the previous claims 1 to 8, wherein the heatsink body is of aluminium and the heatsink insert is of aluminium, copper, silver, gold, synthetic diamond or alloys or mixtures having the materials.

10. A heatsink according to any one of the previous claims 1 to 9, wherein the heat transferring element is a heat pipe, a vapor chamber, graphite material structure or graphene material structure.

11. A heatsink insert adapted to be attached to a base plate of a heatsink body and formed of a material having a thermal conductivity higher than the thermal conductivity of aluminium, the heatsink insert comprising at least one heat transferring element embedded in the heatsink insert.

12. A heatsink insert according to claim 11, wherein the heatsink insert comprises a bottom surface and top surface, the top surface being adapted to be in thermal connection with the base plate of the heatsink body and the bottom surface is adapted to be in thermal connection with a heat source, such as a power electronic module.

13. A heatsink insert according to claim 12, wherein at least one of the heat transferring elements is arranged to form a part of the bottom surface of the heatsink insert.

14. A heatsink insert according to any one of the previous claims 11 to 13, wherein the heatsink insert is of aluminium, copper, silver, gold, synthetic diamond or alloys or mixtures of the materials, and/or the heat transferring element is a heat pipe, a vapor chamber, graphite material structure or graphene material structure.

15. A heatsink insert according to any one of the previous claims 11 to 14, wherein the heatsink insert comprises holes for fastening the insert to the heatsink body with screws.

16. A method of manufacturing a heatsink comprising
providing a heatsink body having a heatsink base plate,
providing a heatsink insert comprising at least one heat transferring element embedded in the heatsink insert, the material of the heatsink insert having a higher thermal conductivity than the material of the heatsink body, and
attaching the heatsink insert to the heatsink body in a thermally conductive manner.
